# DEMANDE DE BREVET EUROPEEN

(11) **EP 0 843 507 A2**
(43) Date de publication de la demande: **20.05.1998**
(21) Numéro de dépôt: 97500168.6
(22) Date de dépôt: 09.10.1997
(51) Int. Cl.: H05K 3/06, H05K 3/42

(54) **Un procédé de fabrication de circuits imprimes mixtes de 105 à 400 et de 17 à 105 microns**

(30) Priorité: 29.10.1996 ES 9602286
(71) Demandeur: MECANISMOS AUXILIARES INDUSTRIALES S.A. M.A.I.S.A., E-43800 Valls, Tarragona (ES)
(72) Inventeur: Buixadera Ferrer, Joan Maria, 43800 Valls, (Tarragona) (ES)
(74) Mandataire: Morgades Manonelles, Juan Antonio

(57) **Abrégé**

Les opérations de fabrication de circuit mixte de 400/35 microns, le procédé de fabrication commence par un usinage préalable du support diélectrique par le biais d'une opération de perçage (19), programmée conformément à la conception finale du circuit imprimé, suivie d'une pose de graphite (21) dans les trous préalablement percés, pour être ensuite suivie d'une impression (22) avec la peinture du négatif du circuit, et soumise à la métallisation (23) à l'aide de cuivre électrolytique et de la protection (29) ultérieure du positif par un alliage de Sn/Pb.

## Description

La présente sollicitude de brevet d invention consiste, conformément à son énoncé, en "UN PROCEDE DE FABRICATION DE CIRCUITS IMPRIMES MIXTES de 105 à 400 et de 17 à 105 MICRONS" dont les nouvelles caractéristiques de construction, conformation et conception remplissent la mission pour laquelle ils ont été spécifiquement conçus avec un maximum de sécurité et d'efficacité.

L invention objet de la présente sollicitude appartient au secteur industriel de la fabrication de circuits imprimés. L'on entend généralement par "circuit imprimé" une plaque de matériel de préférence isolant et qui sert de support à des composants électroniques ou électriques, et sur laquelle est déposée une fine couche de matériel conducteur, habituellement du cuivre ou de l'aluminium, de sorte qu elle effectue les interconnexions nécessaires entre les composants, le câblage conventionnel étant ainsi remplacé.

Pour la construction des circuits imprimés, l'on part de la plaque isolante susmentionnée, généralement en Bakélite ou en matière plastique, sur laquelle est collée une couche de matériel conducteur, couramment du cuivre. Sur cette couche sont dessinées les pistes conductrices qui sont recouvertes d un type de substance résistante aux acides et aux bases. Le reste du matériel conducteur est ainsi éliminé par attaque chimique.

Ensuite, 1 on procède à un simple usinage sur lequel est percée la plaque en des points déterminés par où doivent passer les fils de connexion des composants et, ceux-ci étant placés, l'on procède à l'opération de soudure qui peut être effectuée en plongeant la plaque dans un bain d étain.

Lors du processus d attaque chimique par le biais des acides ou bases mentionnées plus haut pour l'obtention de pistes nécessaires à la formation des différents circuits, l'on fait passer les circuits par une machine tunnel disposant d une série de douches en haut et en bas lorsqu il s'agit de circuits imprimés doubles, c'est à dire avec une couche conductrice sur les deux faces.

Dans le brevet d invention P9200325 du même titulaire est décrite et revendiquée une boîte du type de celles dénommées de "services" à l'intérieur de laquelle se trouvent des circuits imprimés de différentes caractéristiques dont celles décrites plus haut comme doubles et dont le but est, comme cela est décrit dans le brevet nº 9500446(7), également du même titulaire, de servir de support aux composants électriques et électroniques de puissance. Pour l'optimalisation de ce type de circuits imprimés doubles et comme cela a été revendiqué dans le brevet nº 9500446(7), le circuit imprimé doit avoir une face, celle des composants électroniques, d'une épaisseur de cuivre de 35 microns, un circuit de signal et sur l'autre face une épaisseur de 400 microns de cuivre (circuits de puissance).

Les procédés actuels de fabrication prévoient des machines pour l'obtention de circuits de 17 à 105 microns, ou pour l'obtention de circuits de 105 à 400 microns, mais pas pour des circuits mixtes, c'est à dire une face de 17 à 105 microns et la face opposée de 105 à 400 microns.

La difficulté est que ces procédés sont basés sur des attaques chimiques de la manière énoncée plus haut. Avec le problème supplémentaire que le temps nécessaire pour attaquer le circuit de 400 microns est environ onze fois plus long que celui de 35 microns, et pour cela l'on utilise des machines aux dimensions appropriées à chaque cas, telles que celles décrites précédemment, mais étant donné la différence d épaisseur de cuivre à éliminer dans les circuits mixtes, l'obtention de ceux-ci n'est pas possible, même en arrêtant les douches de la partie supérieure de la machine à tunnel.

Pour résoudre le problème des vitesses différentes et obtenir un circuit de 35/400 microns, l'on a d'abord pensé à un nouveau procédé qui consistait essentiellement à unir les deux procédés fondamentaux de gravure individuels et incorporer une nouvelle opération de protection par teinture de la face de 35 microns, afin d'éviter qu'elle ne disparaisse complètement au cours de la gravure du côté de 400 microns.

D'autres détails et caractéristiques de la sollicitude actuelle de patente d'invention seront présentés dans la description ci-dessous qui fait référence aux figures jointes à ce mémoire dans lequel sont représentés d'une façon quelque peu schématique les détails préférés. Ces détails sont donnés à titre d exemple et font référence à un cas possible de réalisation pratique, cet exemple ne demeurant pas limité aux détails qui sont exposés; ainsi, cette description doit être considérée d'un point de vue illustratif et sans limitation d'aucune sorte.

Voici une liste détaillée des divers éléments cités dans la présente sollicitude d'invention: (12) gravure, (14) décapage avec peinture, (16) solder mask entrepistes, (17) opération de solder mask, (18) sérigraphie de composants, (19) opération de perçage, (20) passivé, (21) pose de graphite, (22) impression avec peinture, (23) métallisation, (24) protection avec étain plomb, (25) lavage de la peinture, (27) découpage de circuits en ruche, (28) passivé ou étamé, (29) décapage, (30) peinture.

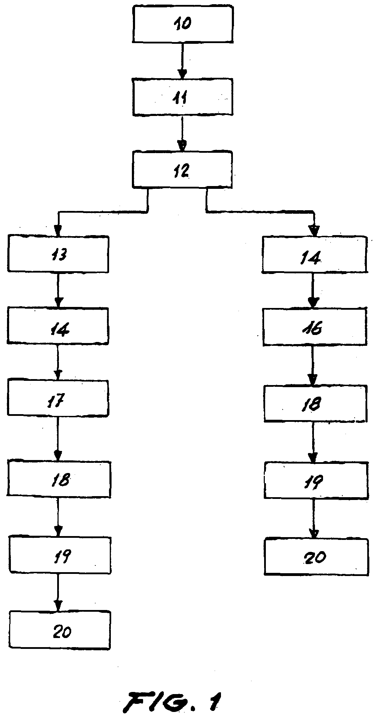

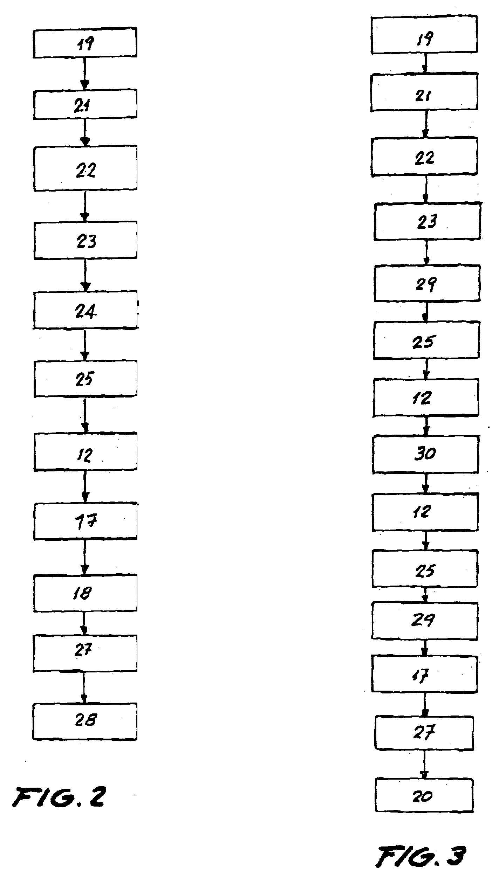

La figure nº1 est un diagramme de blocs du procédé de fabrication d un circuit imprimé de 105 à 400 microns. La figure nº2 est un diagramme de blocs du procédé de fabrication d un circuit imprimé mixte de 17 à 105 microns avec perçage métallisé.

La figure nº3 est un diagramme de blocs du procédé de fabrication d un circuit imprimé mixte de 105 à 400 et 105 à 105 microns avec perçage métallisé.

Dans 1 une des réalisations préférées de ce qui est 1 objet de la présente demande, tel que 1 on peut observer sur le diagramme de la figure nº3 schématisant les opérations de fabrication de circuit mixte de 400/35 microns, le procédé de fabrication commence par un usinage préalable du support diélectrique par le biais d'une opération de perçage (19), programmée conformément à la conception finale du circuit imprimé, suivie d'une pose de graphite (21) dans les trous préalablement percés, pour être ensuite suivie d'une impression (22) avec la peinture du négatif du circuit, et soumise à la métallisation (23) à l'aide de cuivre électrolytique et de la protection (29) ultérieure du positif par un alliage de Sn/Pb.

A l'aide des récipients appropriés suit un lavage de la peinture (25), et la gravure du circuit de l'une des faces de 35 microns, qui est alors protégée par la peinture (30). Ensuite, 1 on procède à la gravure (12) de 1 autre face de 400 microns, au lavage (15) de peinture et au décapage du Sn/Pb (29), pour ensuite entamer l'opération de solder mask (17) de l'entrepiste par rideau photosensible.

Après une description suffisante permettant de savoir en quoi consiste la présente sollicitude de patente d invention correspondant aux plans ci-joints, il est entendu qu'il sera possible d introduire toute modification de détail jugée opportune, à la condition que les variations introduites n altèrent pas 1 essence de la présente patente d invention qui est résumée dans les revendications suivantes.

## Revendications

1. "UN PROCEDE DE FABRICATION DE CIRCUITS MIXTES de 105 à 400 et de 17 à 105 MICRONS" du type de ceux qui sont utilisés pour l'intégration des dénommées boîtes de services, combinant des circuits de signal et des circuits de puissance se caractérisant par le fait que les procédés de gravure (12) des faces de 35 microns et des faces de 400 microns sont unies et exécutées en continu, protégées par la peinture de la face de 35 microns, cependant que dure la gravure (12) de la piste de 400 microns, à 1 intérieur d une machine à tunnel.
